(19) Europäisches Patentamt / European Patent Office / Office européen des brevets

(11) **EP 2 454 395 B1**

(12) **FASCICULE DE BREVET EUROPEEN**

(45) Date de publication et mention de la délivrance du brevet:
**11.09.2013 Bulletin 2013/37**

(21) Numéro de dépôt: **10737975.2**

(22) Date de dépôt: **09.06.2010**

(51) Int Cl.:
*C23C 16/56* (2006.01)   *C30B 33/12* (2006.01)
*C23C 16/26* (2006.01)

(86) Numéro de dépôt international:
**PCT/FR2010/051144**

(87) Numéro de publication internationale:
**WO 2011/007064 (20.01.2011 Gazette 2011/03)**

(54) **PROCÉDÉ POUR LA TEXTURATION DE REVÊTEMENTS TYPE DLC, ET REVÊTEMENTS TYPE DLC AINSI TEXTURÉS**

VERFAHREN ZUR STRUKTURIERUNG VON DLC-BESCHICHTUNGEN UND AUF DIESE WEISE STRUKTURIERTE DLC-BESCHICHTUNGEN

METHOD FOR TEXTURING DLC COATINGS, AND THUS-TEXTURED DLC COATINGS

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **17.07.2009 FR 0954965**

(43) Date de publication de la demande:
**23.05.2012 Bulletin 2012/21**

(73) Titulaire: **Commissariat à l'Énergie Atomique et aux Énergies Alternatives 75015 Paris (FR)**

(72) Inventeurs:
• **CHOUQUET, Caroline**
  **F-56530 Gestel (FR)**
• **DUCROS, Cédric**
  **F-38690 Bevenais (FR)**
• **GAVILLET, Jérôme**
  **F-38120 Saint Egreve (FR)**
• **SANCHETTE, Frédéric**
  **F-38620 Montferrat (FR)**

(74) Mandataire: **Vuillermoz, Bruno et al Cabinet Laurent & Charras "Le Contemporain" 50, Chemin de la Bruyère 69574 Dardilly Cédex (FR)**

(56) Documents cités:
**EP-A- 1 947 220       WO-A-2008/001670**
**US-A1- 2006 246 218    US-B1- 6 524 874**

• YASUMARU ET AL: "Control of tribological properties of diamond-like carbon films with femtosecond-laser-induced nanostructuring" APPLIED SURFACE SCIENCE, ELSEVIER, AMSTERDAM, NL, vol. 254, no. 8, 1 février 2008 (2008-02-01), pages 2364-2368, XP022449365 ISSN: 0169-4332
• PETTERSSON ET AL.: "Friction and wear properties of micro textured DLC coated surfaces in boundary sliding" TRIBOLOGY LETTERS, vol. 17, no. 3, octobre 2004 (2004-10), pages 553-559, XP002563804
• MARCIANO ET AL.: "Use of near atmospheric pressure and low pressure techniques to modification DLC film surface" SURFACE & COATINGS TECHNOLOGY, vol. 204, 9 juillet 2009 (2009-07-09), pages 64-68, XP002563805

**Description**

**DOMAINE DE L'INVENTION**

La présente invention vise en premier lieu un procédé particulier permettant de modifier et notamment de texturer un revêtement de surface, type DLC, pour l'acronyme anglo-saxon *«Diamond Like Carbon»*.

De tels revêtements ou films sont aujourd'hui bien connus et sont typiquement constitués d'un film de carbone amorphe hydrogéné, dont les propriétés de haute dureté, de faible coefficient de frottement, d'adhérence d'isolation électrique et d'inertie chimique sont mises en oeuvre, notamment pour des applications tribologiques.

Sous le vocable « type DLC », on entend principalement un matériau dit carbone amorphe hydrogéné noté a-C:H ; sachant que le DLC est bien défini dans la littérature (J. Robertson, Materials Science and Engineering R(27), 2002, 129-281.)

Dans l'art antérieur il est connu de modifier par texturation la surface d'un revêtement du type DLC pour influencer des propriétés tribologiques (F.R.Marciano et al., Surface & Coatings Technology 204, 2009, 64- 68; N Yakumara et al. Applied Surface Science 254, 2008, 2364- 2368; U. Pettersson et al., Tribology Letters 17 (3) , 2004, 553- 559) .

Nonobstant les qualités de faible coefficient de frottement des revêtements DLC connus à ce jour, on cherche à optimiser de telles qualités pour des applications particulières.

C'est l'objet de la présente invention.

**EXPOSE DE L'INVENTION**

L'invention vise un procédé de texturation de revêtements type DLC qui consiste :

- à déposer une monocouche de billes ou sphères sur la surface libre ou supérieure du revêtement DLC,
- à réaliser une gravure sèche du revêtement DLC par plasma oxygène,
- et enfin, à nettoyer la surface dudit revêtement par élimination des billes ou sphères.

En d'autres termes, l'invention consiste à réaliser la texturation d'un revêtement DLC par un procédé simple, se limitant à la mise en oeuvre de trois étapes, en s'affranchissant des techniques classiques de gravure type lithographie.

Ce faisant, le procédé de l'invention permet de limiter les dommages éventuels susceptibles d'affecter le revêtement DLC que les procédés de gravure par ablation laser par exemple sont susceptibles de générer avec, à la clé, une dégradation des propriétés dudit revêtement.

L'invention est en particulier bien adaptée au traitement de surface de revêtements DLC de pièces mécaniques moteur présentant des reliefs, c'est à dire non planes, en particulier de celles ayant une géométrie en 3D.

Selon l'invention, on entend par DLC un matériau carbone amorphe hydrogéné noté a-C:H

Selon l'invention, le dépôt de la monocouche de billes ou sphères peut être réalisé par la technique dite de *« Langmuir-Blodgett »*. Cette technique, aujourd'hui bien maîtrisée, permet le transfert d'une monocouche de nano ou micro particules d'un bain liquide vers la surface d'un substrat.

Ce faisant, il est possible, avec cette technique, de déposer des billes ou sphères de nature différente, notamment réalisées en silice ou en polymères, notamment de type latex ou polystyrène, lesdites billes ou sphères étant susceptibles de présenter un diamètre compris entre 100 nanomètres et plus de 10 micromètres. Cette technique est connue pour permettre l'obtention d'une monocouche de billes ou sphères uniforme, avec un taux d'organisation élevé.

Alternativement, le dépôt de la monocouche des billes ou sphères peut être réalisé par la technologie dite de *« dip coating »* également connue sous le nom de trempage/ retrait. Cette technologie sera préférée lorsque l'on souhaite texturer des surfaces importantes ou des géométries tridimensionnelles.

De surcroit, le bain liquide peut contenir outre le solvant de dispersion des billes ou sphères, un tensio-actif, par exemple le triton X-100®.

Selon l'invention, la gravure sèche du revêtement DLC est réalisée par chimie sélective, notamment sous plasma oxygène, permettant une attaque préférentielle du revêtement DLC en lieu et place du matériau constitutif des billes ou sphères, typiquement la silice. Alternativement, les billes peuvent être composées de polymère de type Latex ou polystyrène.

Selon l'invention, le nettoyage de la surface du revêtement DLC, après gravure, peut être réalisé dans un bain d'éthanol permettant d'éliminer lesdites billes ou sphères. Par élimination, on entend l'évacuation des billes de la surface.

En raison du traitement opéré, la texturation réalisée à la surface du revêtement DLC se caractérise par la présence d'ouvertures ou de cavités de dimensions variables, la taille desdites cavités étant conditionnée par la taille des billes utilisées. Eventuellement, les cavités peuvent être communicantes entre elles.

Selon l'invention, ce taux d'ouverture, c'est-à-dire le nombre d'ouvertures par unité de surface, peut être augmenté en réalisant une étape intermédiaire de gravure sous plasma $SF_6 + CHF_3$, préalablement à la gravure sous plasma d'oxygène.

L'invention vise également les pièces mécaniques d'usure ou de frottement présentant un revêtement de surface type DLC, texturé selon le procédé de l'invention.

Ainsi, le revêtement de ces pièces mécaniques peut présenter un taux d'ouverture, c'est- à- dire le nombre d'ouvertures ou de cavités par unité de surface dudit revêtement supérieur à 10%.

En outre, partie au moins des ouvertures ou cavités présentes à la surface du revêtement type DLC sont communicantes, de telle sorte à favoriser la circulation d'un lubrifiant.

## BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées parmi lesquelles :

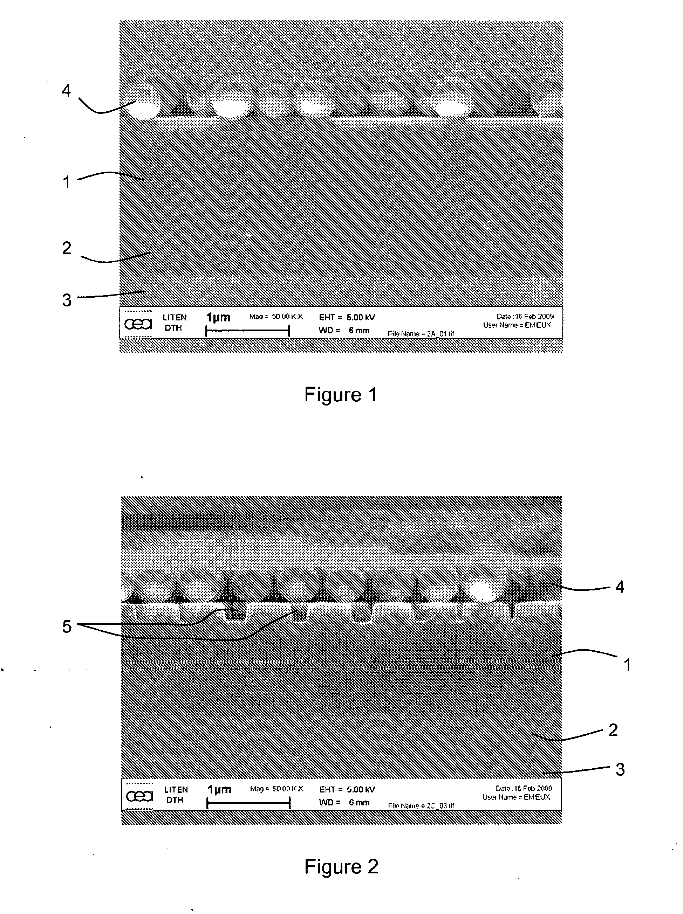

La figure 1 est une représentation schématique en vue latérale d'un substrat revêtu d'un revêtement DLC et de la monocouche de billes ou sphères conformément au procédé de l'invention.
La figure 2 est une vue analogue à la figure 1, obtenue consécutivement à l'étape de gravure.
La figure 3 est une vue de la surface du revêtement après nettoyage, c'est-à-dire après enlèvement de la couche de billes ou sphères, dont la figure 4 est une vue de dessus.
Les figures 5 et 6 sont des graphes illustrant la variation du coefficient de frottement en fonction de la distance parcourue par une bille en acier au sein d'un dispositif tribométrique de type « ball- on-disk », respectivement pour un revêtement DLC non texturé et pour un revêtement texturé conformément à l'invention.

## DESCRIPTION DETAILLEE DE L'INVENTION

Selon l'invention, la première étape du procédé consiste donc à déposer une monocouche (4) de billes ou sphères à la surface d'un revêtement DLC (1). Celui-ci est classiquement déposé sur un substrat (3), préalablement revêtu d'une couche d'accroche (2) qui peut être par exemple en carbure de silicium hydrogénée.

A cet effet, on peut utiliser un équipement de la société NANOMETRIX adapté à la technique « Langmuir-Blodgett ».

On utilise à cet effet des billes réalisées en silice, présentant un diamètre d'un micromètre avec dispersion d'environ 10 %, lesdites billes étant mises en solution dans un solvant avantageusement constitué de butanol.

Alternativement, on peut utiliser un mélange d'eau et d'éthanol. La condition requise est de disposer d'une mouillabilité suffisante du DLC par le solvant contenant les billes.

La solution utilisée présente une concentration en billes de l'ordre de 37,5 g/l. Cette concentration doit être en général comprise entre 30 et 50 g/l.

Une fois le dépôt de billes effectué, l'évaporation du solvant sous air permet de figer la structure auto-organisée des billes en surface du revêtement.

On procède alors à la seconde étape du procédé de l'invention qui concerne la gravure plasma de la couche de revêtement DLC. Cette gravure est réalisée selon la technique RIE « *Reactive Ion Etching* » avec les paramètres suivants :

| | |
|---|---|
| Nature du gaz : | Oxygène |
| Debit : | 80 sccm |
| Puissance : | 10 W |
| Pression : | 3 Pa |
| Tension : | 320 V. |

La mise en oeuvre de cette gravure sous ces conditions permet de disposer d'une vitesse de gravure de la couche de DLC de l'ordre de 0,53 nm/s.

La mise en oeuvre d'un tel plasma sous oxygène permet d'obtenir une sélectivité très importante, typiquement dans un rapport de 22 à 1 entre le revêtement DLC et de la silice constitutive des billes. Ce faisant, ledit revêtement DLC est très préférentiellement attaqué par le plasma en lieu et place des billes, ces dernières faisant en quelque sorte fonction de masque. Il se crée de la sorte des cavités (5) s'étendant depuis la surface supérieure (6) du revêtement DLC.

On procède alors au nettoyage de la surface du revêtement DLC après gravure. Ce nettoyage consiste à retirer la monocouche de billes. Ce retrait est typiquement obtenu par trempage de l'ensemble après gravure dans un bain d'éthanol pendant quinze minutes et soumission aux ultrasons. Alternativement aux ultrasons, on peut employer toute technique mécanique douce (frottement, balayage, etc...), visant à décrocher les billes du revêtement.

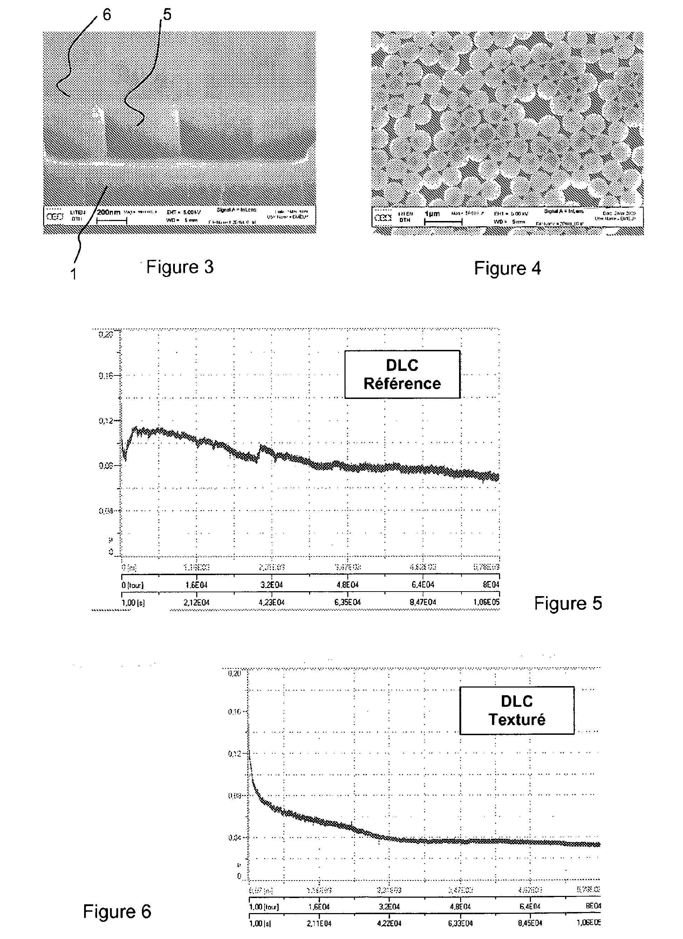

On obtient ainsi un revêtement du type illustré aux figures 3 et 4. On observe notamment la réalisation de motifs de gravure (5) présentant des dimensions variables, la taille desdits motifs ou cavités étant conditionnée par la taille des billes utilisées.

On relève que si l'on considère un empilement compact, c'est-à-dire au maximum de l'auto-organisation possible des billes ou sphères en surface du revêtement, le volume V d'une cavité est donné par la relation suivante :

$$V = \left(\sqrt{3} - \frac{\pi}{2}\right) r^2 d$$

expression dans laquelle :

- r désigne le rayon d'une bille
- et d est la profondeur de la cavité.

On observe que quelle que soit la taille des billes utilisées, un empilement compact aboutit à un taux d'ouverture voisin de 10 %, la taille des billes conditionnant alors uniquement la taille des cavités ou ouvertures.

Cependant, ce taux peut être augmenté en réalisant une étape de gravure intermédiaire, sous plasma $SF_6$ + $CHF_3$, ce qui permet alors de diminuer la taille des billes.

Ladite étape intermédiaire permet de graver cette fois ci sélectivement les billes de silice versus le revêtement type DLC. Le diamètre moyen des billes se trouve alors réduit mais l'auto-organisation perdure, le plasma $SF_6$+$CHF_3$ n'étant pas de nature à modifier l'organisation des billes entre elles, ces dernières restent positionnées au même endroit qu'à l'issue de l'étape de dépôt de la monocouche.

Ainsi, en réduisant le diamètre des billes de 500 nm à 400 nm, le taux d'ouverture du motif est augmenté de 10 à 42 %.

Ce faisant, préalablement à la gravure sèche du revêtement DLC, il peut-être réalisée une gravure contrôlée des billes ou sphères, par chimie sélective, notamment sous plasma $SF_6$ + $CHF_3$.

Il devient alors possible d'ajuster les dimensions des motifs ou des cavités à la surface du revêtement DLC en fonction de la géométrie et de la taille du contact étudié, et ainsi de moduler les propriétés tribologiques du revêtement.

En particulier, cette étape de gravure supplémentaire permet la création de cavités totalement communicantes, régulières et non directionnelles, permettant de faire circuler un fluide d'intérêt, par exemple un lubrifiant, lors de l'utilisation d'une pièce à usage mécanique pourvue d'un tel revêtement. Ledit lubrifiant n'est plus alors cantonné aux cavités discrètes, ce qui assure une meilleure répartition du lubrifiant sur l'ensemble de la pièce et en particulier là où les sollicitations mécaniques du type frottement sont subies.

Les essais réalisés montrent que la texturation du revêtement DLC ne présente pas de direction privilégiée, de sorte que les motifs obtenus ne conditionnent pas la direction du frottement, contrairement aux procédés de texturation obtenus par des techniques antérieures qui génèrent des motifs réguliers et directionnels.

Des essais de tribologie ont été réalisés sur les revêtements obtenus conformément à l'invention au moyen d'un tribomètre de type « ball-on-disk » fourni par la société CSM utilisant une bille en acier 100Cr6.

On obtient les résultats visés aux figures 5 et 6 avec les paramètres d'utilisation suivants :

- pression de Hertz : 1,1 GPa
- vitesse de rotation : 5,5 cm/s
- distance parcourue : 5780 m
- lubrifiant moteur : 8mL (huile standard)

On observe ainsi, sur les graphes des figures 5 et 6, l'évolution du coefficient de frottement en fonction de la distance parcourue par la bille, respectivement pour un revêtement DLC non texturé (figure 5), et pour un revêtement DLC texturé conformément à l'invention (figure 6) à partir d'un masquage réalisé avec des billes en silice de diamètre 1 μm et une profondeur de gravure du revêtement DLC de l'ordre de 300 nm.

On relève ainsi que le coefficient de frottement est de l'ordre de 0,07 pour un revêtement DLC non texturé, alors qu'il se situe aux alentours de 0,035 pour le DLC texturé, soulignant de la sorte l'optimisation des propriétés tribologiques.

L'invention concerne également l'utilisation du procédé défini précédemment pour la réalisation de pièces mécaniques soumises à une usure ou un frottement par friction. En particulier, ce procédé simple à mettre en oeuvre est immédiatement accessible pour des pièces à géométrie complexe.

**Revendications**

1. Procédé de texturation d'un revêtement DLC qui consiste :

   - à déposer une monocouche de billes ou sphères sur la surface libre du revêtement DLC,
   - à réaliser une gravure sèche du revêtement DLC par plasma oxygène,
   - et enfin, à nettoyer la surface dudit revêtement par élimination des billes ou sphères.

2. Procédé de texturation d'un revêtement DLC selon la revendication 1, *caractérisé* **en ce que** le dépôt de la monocouche de billes ou sphères est réalisé par la technique de *« Langmuir-Blodgett »*.

3. Procédé de texturation d'un revêtement DLC selon la revendication 1, *caractérisé* **en ce que** le dépôt de la monocouche de billes ou sphères est réalisé par la technologie de *« dip coating »* ou trempage/retrait.

4. Procédé de texturation d'un revêtement DLC selon l'une des revendications 1 à 3, *caractérisé* **en ce que** préalablement à la gravure sèche du revêtement DLC, il est réalisée une gravure contrôlée des billes ou sphères, par chimie sélective, notamment sous plasma $SF_6$ + $CHF_3$.

5. Procédé de texturation d'un revêtement DLC selon l'une des revendications 1 à 4, *caractérisé* **en ce que** le nettoyage de la surface du revêtement DLC, après gravure, est réalisé par trempage dans un bain d'éthanol permettant d'éliminer lesdites billes ou sphères.

6. Procédé de texturation d'un revêtement DLC selon la revendication 5, *caractérisé* **en ce que** le bain d'éthanol est en outre soumis à des ultrasons.

7. Procédé de texturation d'un revêtement DLC selon l'une des revendications 1 à 6, *caractérisé* **en ce**

**que** les billes ou sphères sont réalisées en silice ou en polymères notamment de type Latex ou polystyrène.

8. Procédé de texturation d'un revêtement DLC selon l'une des revendications 1 à 7, *caractérisé* **en ce que** le diamètre des billes ou sphères est compris entre 100 nanomètres et 10 micromètres.

9. Utilisation du procédé selon l'une quelconque des revendications 1 à 8 pour la réalisation de pièces mécaniques soumises à une usure ou un frottement par friction.

10. Pièce mécanique d'usure ou de frottement présentant un revêtement de surface type DLC texturé selon le procédé de l'une quelconque des revendications 1 à 8, présentant des cavités en suite de la texturation, dont le volume V est donné par la relation suivante :

$$V = \left(\sqrt{3} - \frac{\pi}{2}\right) r^2 d$$

expression dans laquelle :

- r désigne le rayon d'une bille ou sphère,
- et d est la profondeur de la cavité.

**Patentansprüche**

1. Texturierungsverfahren für eine DLC-Beschichtung, das darin besteht:

   - eine einlagige Schicht aus Kügelchen oder Kugeln auf der freien Oberfläche der DLC-Beschichtung abzuscheiden,
   - einen Trockenätzprozess an der DLC-Beschichtung mittels Sauerstoffplasma durchzuführen,
   - und schließlich die Oberfläche der Beschichtung durch Entfernen der Kügelchen oder Kugeln zu reinigen.

2. Texturierungsverfahren für eine DLC-Beschichtung nach Anspruch 1, **dadurch gekennzeichnet, dass** die Abscheidung der einlagigen Schicht aus Kügelchen oder Kugeln durch die Technik von *"Langmuir-Blodgett* erfolgt.

3. Texturierungsverfahren für eine DLC-Beschichtung nach Anspruch 1, **dadurch gekennzeichnet, dass** die Abscheidung der einlagigen Schicht aus Kügelchen oder Kugeln durch die *"dip coating"* oder Eintauch/Entnahme-Technologie erfolgt.

4. Texturierungsverfahren für eine DLC-Beschichtung nach einem der Ansprüche 1 bis 3, **dadurch gekennzeichnet, dass** vor dem Trockenätzprozess an der DLC-Beschichtung ein gesteuerter Ätzprozess an den Kügelchen oder Kugeln mittels selektiver Chemie, insbesondere unter $SF_6 + CHF_3$-Plasma erfolgt.

5. Texturierungsverfahren für eine DLC-Beschichtung nach einem der Ansprüche 1 bis 4, **dadurch gekennzeichnet, dass** die Reinigung der Oberfläche der DLC-Beschichtung nach dem Ätzprozess durch Eintauchen in ein Ethanolbad erfolgt, das es ermöglicht, die Kügelchen oder Kugeln zu entfernen.

6. Texturierungsverfahren für eine DLC-Beschichtung nach Anspruch 5, **dadurch gekennzeichnet, dass** das Ethanolbad außerdem Ultraschall ausgesetzt wird.

7. Texturierungsverfahren für eine DLC-Beschichtung nach einem der Ansprüche 1 bis 6, **dadurch gekennzeichnet, dass** die Kügelchen oder Kugeln aus Siliciumoxid oder aus Polymeren der Art Latex oder Polystyrol bestehen.

8. Texturierungsverfahren für eine DLC-Beschichtung nach einem der Ansprüche 1 bis 7, **dadurch gekennzeichnet, dass** der Durchmesser der Kügelchen oder Kugeln zwischen 100 Nanometer und 10 Mikrometer beträgt.

9. Verwendung des Verfahrens nach einem der Ansprüche 1 bis 8 zur Herstellung von mechanischen Teilen, die einem Verschleiß oder einer Schleifreibung ausgesetzt sind.

10. Mechanisches Verschleiß- oder Schleifreibungsteil, das eine nach dem Verfahren nach einem der Ansprüche 1 bis 8 texturierte DLC-Oberflächenbeschichtung aufweist, das Hohlräume infolge der Texturierung aufweist, deren Volumen V durch das folgende Verhältnis gegeben ist:

$$V = \left(\sqrt{3} - \frac{\pi}{2}\right) r^2 d$$

wobei in diesem Ausdruck:

- r den Radius eines Kügelchens oder einer Kugel bezeichnet,
- und es sich bei d um die Tiefe des Hohlraums handelt.

**Claims**

1. A method for texturing a DLC coating which comprises:

   - depositing a single layer of balls or spheres on the free surface of the DLC coating,
   - dry-etching the DLC coating using oxygen plasma,
   - and lastly, cleaning said coating by removing the balls or spheres.

2. The method for texturing a DLC coating, as claimed in claim 1, wherein the single layer of balls or spheres is deposited using the Langmuir-Blodgett technique.

3. The method for texturing a DLC coating, as claimed in claim 1, wherein the single layer of balls or spheres is deposited using dip-coating technology.

4. The method for texturing a DLC coating, as claimed in one of claims 1 to 3, wherein prior to the dry-etching of the DLC coating, a controlled etching of the balls or spheres is carried out, by selective chemistry, and in particular using $SF_6$ + $CHF_3$ plasma.

5. The method for texturing a DLC coating, as claimed in one of claims 1 to 4, wherein the surface of the DLC coating is cleaned, after etching, by soaking in an ethanol bath to remove said balls or spheres.

6. The method for texturing a DLC coating, as claimed in claim 5, wherein the ethanol bath is additionally subjected to ultrasonics.

7. Method for texturing a DLC coating, as claimed in one of claims 1 to 6, wherein the balls or spheres are made of silica or polymers such as in particular Latex or polystyrene.

8. The method for texturing a DLC coating, as claimed in one of claims 1 to 7, wherein the diameter of the balls or spheres is between 100 nanometres and 10 micrometres.

9. Use of the method as claimed in any one of claims 1 to 8 for the production of machine parts subject to wear or frictioning.

10. A machine wear or friction part having a textured DLC surface coating according to the method claimed in any one of claims 1 to 8, that has cavities subsequent to texturing, whereof the volume V is given by the following relation:

$$V = \left(\sqrt{3} - \frac{\pi}{2}\right)r^2 d$$

an expression wherein:

   - r denotes the radius of a ball or sphere,
   - and d is the depth of the cavity.

Figure 1

Figure 2

Figure 3

Figure 4

DLC
Référence

Figure 5

DLC
Texturé

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J. ROBERTSON.** *Materials Science and Engineering,* 2002, vol. R (27), 129-281
- **F.R.MARCIANO et al.** *Surface & Coatings Technology,* 2009, vol. 204, 64-68
- **N YAKUMARA et al.** *Applied Surface Science,* 2008, vol. 254, 2364-2368
- **U. PETTERSSON et al.** *Tribology Letters,* 2004, vol. 17 (3), 553-559